# EUROPÄISCHE PATENTANMELDUNG

(11) **EP 2 528 220 A2**
(43) Veröffentlichungstag der Anmeldung: **28.11.2012**
(21) Anmeldenummer: 12161516.5
(22) Anmeldetag: 27.03.2012
(51) Int. Cl.: H02M 7/00

(54) **Leistungselektronisches System mit Verbindungseinrichtung zwischen erstem und zweitem Subsystem**

(30) Priorität: 24.05.2011 DE 102011076324
(71) Anmelder: SEMIKRON Elektronik GmbH & Co. KG, 90431 Nürnberg (DE)
(72) Erfinder: Frank, Thomas, 91207 Lauf (DE); Popp, Rainer, 91580 Petersaurach (DE); Weiß, Stefan, 91315 Höchstadt (DE)

(57) **Zusammenfassung**

Die Anmeldung betrifft ein leistungselektronisches System mit einer Kühleinrichtung (10), mindestens einem ersten (30) und mindestens einem zweiten Subsystem (31), mindestens einer Verbindungseinrichtung (74,76) und einem Gehäuse (20). Das erste Subsystem weist eine Schalteinrichtung mit einem mit der Kühleinrichtung thermisch leitend verbundenen Kühlbauteil und einer hierauf angeordneten leistungselektronischen Schaltung mit ersten internen Lastanschlusselementen verschiedener Polarität und einen Isolierstoffkörper auf. Das zweite Subsystem ist analog dem ersten Subsystem (30) aufgebaut und weist mindestens ein externes Gleichspannungs-Lastanschlusselement auf. Die mindestens eine Verbindungseinrichtung verbindet interne Lastanschlusselemente erster und zweiter Subsysteme mit einem externen Lastanschlusselement eines zweiten Subsystems.

## Beschreibung

Die Erfindung beschreibt ein integriertes leistungselektronisches System, vorzugsweise zur Ausbildung einer damit realisierten Schaltungsanordnung in Form eines Stromrichters, beispielhaft eines Drei-Phasen-Wechselrichters. Derartige Systeme finden bevorzugt Anwendung in elektrischen Antrieben verschiedener Arten von Fahrzeugen, speziell auch bei Nutzfahrzeugen.

Es ist grundsätzlich bekannt derartige leistungselektronische System aus einzelnen Leistungshalbleitermodulen beispielhaft gemäß der DE 10 2009 037 257 A1 mit externer Verschienung, also der Verbindung der externen Anschlusselemente der Leistungshalbleitermodule miteinander aufzubauen. Derartige Systeme weisen den Vorteil auf durch Skalierung beliebig an die notwendige Leistung angepasst werden zu können. Einher geht damit allerdings auch der Nachteil, dass diese Systeme aus einer Mehrzahl von einzelnen Komponenten bestehen, die mittels externer Verbindungselemente schaltungsgerecht miteinander verbunden werden müssen.

Es ist ebenso bekannt derartige leistungselektronische Systeme als integrierte Systeme, beispielhaft gemäß der DE101 27 947A1 auszugestalten. Bei einem derartigen als Drei-Phasen-Wechselrichter aufgebauten Systemen sind den drei Phasen jeweils eigene Schalteinrichtungen zugeordnet, die mit einer gemeinsamen internen Gleichspannungsverbindung miteinander und mit externen Gleichspannungs-Lastanschlusselementen verbunden sind. Es ist bekannt diese Gleichspannungsverbindung unmittelbar mit einer gemeinsamen Kondensatoreinrichtung für alle Schalteinrichtungen zu verbinden. Derartige Systeme weisen den Vorteil einer kompakten Ausgestaltung bei gleichzeitig hervorragenden elektrischen Eigenschaften auf. Sie bergen allerdings den Nachteil, dass sie durch die Integration vieler Komponenten einer Skalierung und damit einer Anpassung an unterschiedliche Leistungen nicht einfach zugänglich sind.

Der Erfindung liegt die Aufgabe zugrunde ein leistungselektronisches System vorzustellen, das eine kompakte Einheit bildet, modular aufgebaut ist und gleichzeitig einer einfachen Skalierung, also einer Anpassung an unterschiedliche Leistungen und auch der Ausbildung verschiedener Schaltungsanordnungen zugänglich ist.

Die Aufgabe wird erfindungsgemäß gelöst, durch ein leistungselektronisches System mit den Merkmalen des Anspruchs 1. Bevorzugte Ausführungsformen sind in den jeweiligen abhängigen Ansprüchen beschrieben.

Das vorgestellte leistungselektronische System weist eine Kühleinrichtung, mindestens ein erstes und mindestens ein zweites Subsystem, die mittels mindestens einer internen Verbindungseinrichtung miteinander schaltungsgerecht verbunden sind sowie ein die Subsysteme zur Kühleinrichtung hin überdeckendes Gehäuse auf. Vorzugsweise sind alle Subsysteme in einer Reihe nebeneinander angeordnet.

Das mindestens eine erste Subsystem weist eine Schalteinrichtung mit einem Kühlbauteil, einen lsolierstoffkörper und ein externes Wechselspannungs-Lastanschlusselement auf. Die Schalteinrichtung wird vorzugsweise aus einem elektrisch isolierenden Substrat mit auf dessen erster Hauptfläche angeordneten und schaltungsgerecht verbundenen Leistungshalbleiterbauelementen, die die leistungselektronischen Schaltung ausbilden, gebildet. Die Schalteinrichtung weist weiterhin interne Lastanschlusselemente verschiedener Polarität auf, von denen mindestens eines mit dem externen Wechselspannungs-Lastanschlusselement ein- oder mehrstückig verbunden ist.

Das mindestens eine zweite Subsystem ist grundsätzlich analog dem ersten Subsystem aufgebaut, weist allerdings zusätzlich mindestens ein externes Gleichspannungs-Lastanschlusselement, vorzugsweise allerdings zwei, auf, das jeweils geeignet mit dem polaritätsgleichen internen Lastanschlusselement verbunden ist.

Zudem kann es vorteilhaft sein, wenn jedes erste und zweite Subsystem eine eigene Kondensatoreinrichtung aufweist, die mit dem jeweiligen Isolierstoffkörper zu ihrer Fixierung verbunden ist. Hierbei sind dann die Kontakteinrichtungen der Kondensatoreinrichtung mit den internen Lastanschlusselementen der Schalteinrichtung polaritätsrichtig elektrisch leitend verbunden.

Ebenso ist es bevorzugt, wenn eine oder mehrere Subsystem eine Steuerschaltung mit einer zugehörigen Schaltplatine aufweisen. Diese Schaltplatine kann mit den lsolierstoffkörpem zu ihrer Fixierung mechanisch verbunden sein. Ebenso kann diese Schaltplatine mit Hilfsanschlusselementen der Schalteinrichtung elektrisch leitend verbunden sein.

Das leistungselektronische System weist weiterhin mindestens eine Verbindungeinrichtung auf, die interne Lastanschlusselemente mehrerer Subsysteme polaritätsrichtig miteinander verbindet. Es ist hierbei bevorzugt, wenn die internen Lastanschlusselemente aller ersten und zweiten Subsysteme polaritätsrichtig mittels jeweils einer Verbindungseinrichtung miteinander und mit einem zugeordneten externen Lastanschlusselement eines zweiten Subsystems verbunden sind.

Weiterhin ist es bevorzugt, wenn für beide Gleichspannungspotentiale jeweils eine Verbindungseinrichtung vorgesehen ist und diese beiden Verbindungseinrichtungen grundsätzlich gleichartig ausgebildet sind und derart zueinander angeordnet sind, dass die gesamte interne Gleichspannungsverbindung niederinduktiv ausgebildet ist.

Die mindestens eine Verbindungseinrichtung kann hierzu als flächiger Metallformkörper ausgebildet sein mit einem flächigen Verbindungskörper, der gleichzeitig Kontaktstellen aufweisen kann und mit einem Kontaktabschnitt zu einem externen Lastanschlusselement. Dieser jeweilige Kontaktabschnitt kann als eine Lasche ausgebildet sein, die eine Ausnehmung aufweist. Dann ist es bevorzugt, wenn die externe Kontakteinrichtung als ein Schraub- oder Klemmbolzen ausgebildet ist, der durch das Gehäuse des leistungselektronischen Systems hindurchragt und im Inneren des Gehäuse durch dies Ausnehmung der Lasche des Kontaktabschnitts hindurchragt.

Ebenso ist es bevorzugt, wenn das interne Lastanschlusselement das mit dem polaritätsrichtig zugeordneten Verbindungselement elektrisch leitend verbindbar ist als Lasche ausgebildet ist. Diese jeweilige Lasche kann auf Kontaktstellen des Verbindungskörpers der polaritätsrichtig zugeordneten Verbindungseinrichtung aufliegen und kraft- oder stoffschlüssig damit elektrisch leitend verbunden sein. Diese wie alle übrigen kraftschlüssigen Verbindungen können jeweils mittels reversibel anordenbarer Klammer ausgebildet sein. Alternativ oder zusätzlich vorhandenen stoffschlüssige Verbindungen sind vorteilhafterweise als Schweißverbindungen ausgebildet.

Insbesondere ist es vorteilhaft, wenn das leistungselektronische System je erstem und zweitem Subsystem eine Kondensatoreinrichtung aufweist, die mittels zugeordneter Verbindungseinrichtungen polaritätsrichtig elektrisch leitend mit den jeweiligen Verbindungselementen der jeweiligen Schalteinrichtung des Subsystems elektrisch leitend verbunden sind.

Hierzu kann jede Kondensatoreinrichtung je Polarität zwei Laschen aufweisen, wobei die erste mit der polaritätsrichtig zugeordneten Lasche der Schalteinrichtung kraft-oder stoffschlüssig elektrisch leitend verbunden ist und die zweite auf dem Metallformkörper, insbesondere auf Kontaktstellen des Verbindungskörpers, einer polaritätsrichtig zugeordneten Verbindungseinrichtung aufliegt und dort kraft- oder stoffschlüssig mit dieser kraft- oder stoffschlüssig elektrisch leitend verbunden ist.

Mittels derartiger Verbindungseinrichtungen, insbesondere zur internen Gleichspannungsverbindung, kann durch unterschiedliche Ausgestaltung der Metallformkörpers ein einfach skalierbares leistungselektronische System ausgebildet werden. Hierbei kann eine unterschiedliche Anzahl von aneinandergereihten Subsystemen beispielhaft mittels sich in der Länge unterscheidender Verbindungskörper miteinander verbunden werden.

Die erfinderische Lösung wird an Hand der Ausführungsbeispiele gemäß den Fig. 1 bis 4 weiter erläutert.

Fig. 1 zeigt in dreidimensionaler Darstellung ein erfindungsgemäßes leistungselektronisches System mit seinem Gehäuse.

Fig. 2 zeigt eine Draufsicht auf das erfindungsgemäße leistungselektronische System ohne Gehäuse.

Fig. 3 zeigt in dreidimensionaler Darstellung das erfindungsgemäße leistungselektronische System ohne Gehäuse.

Fig. 4 zeigt eine Klemmvorrichtung zur Ausbildung kraftschlüssiger Verbindungen in einem erfindungsgemäßen leistungselektronischen System.

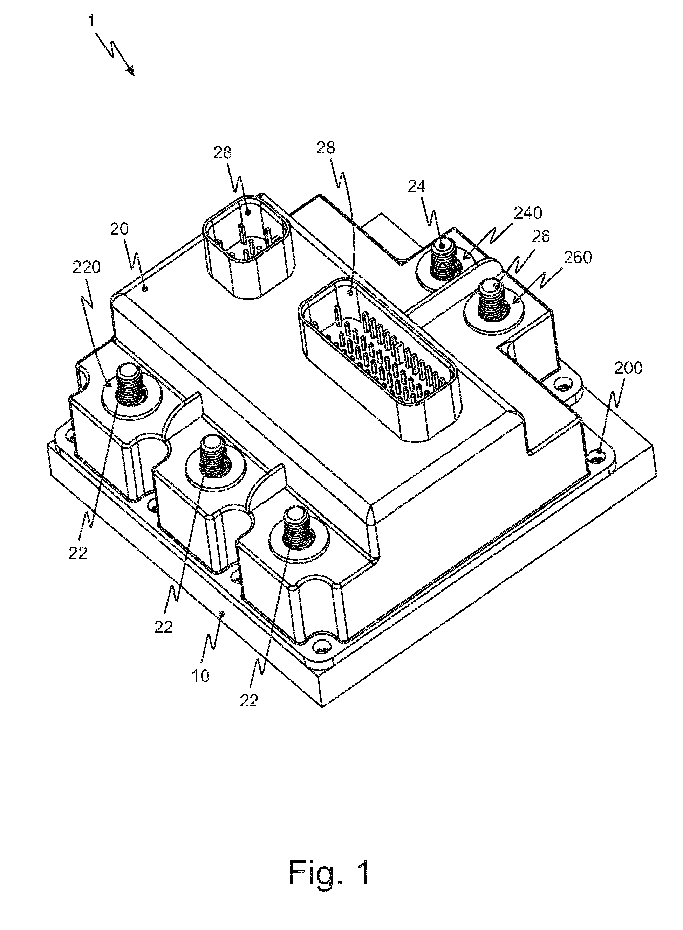

Fig. 1 zeigt in dreidimensionaler Darstellung ein erstes erfindungsgemäßes leistungselektronisches System 1 in Ausgestaltung eines Drei-Phasen-Wechselrichters. Schematisch dargestellt ist eine Kühleinrichtung 10, beispielhaft ausgebildet als eine Wasserkühleinrichtung. Interne Komponenten des Systems werden durch ein Gehäuse 20 zu dieser Kühleinrichtung 10 hin überdeckt. Das Gehäuse 10 selbst wird an entsprechenden Ausnehmungen 220, 240, 260 durch die externen Anschlusselemente 22, 24, 26 durchdrungen.

An einer ersten Seite des Gehäuses 10 sind die beiden externen Gleichspannungs-Lastanschlusselemente 24, 26 angeordnet, die als Schraubverbindungen ausgebildet sind. Auf der gegenüberliegenden zweiten Seite des Gehäuses 10 sind die externen Wechselspannungs-Lastanschlusselemente 22 in grundsätzlich gleicher technischer Ausprägung dargestellt.

An der Oberseite sind in zwei Gruppen externer Hilfsanschlusselemente 28 vorgesehen, die insbesondere zum Anschluss von Steuer- und Sensorsignalen dienen.

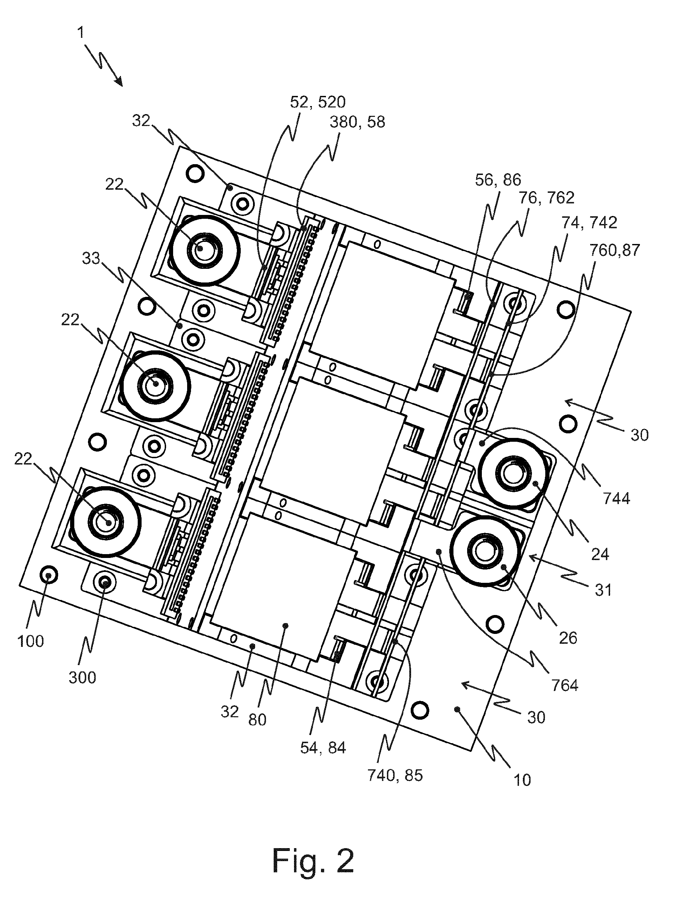

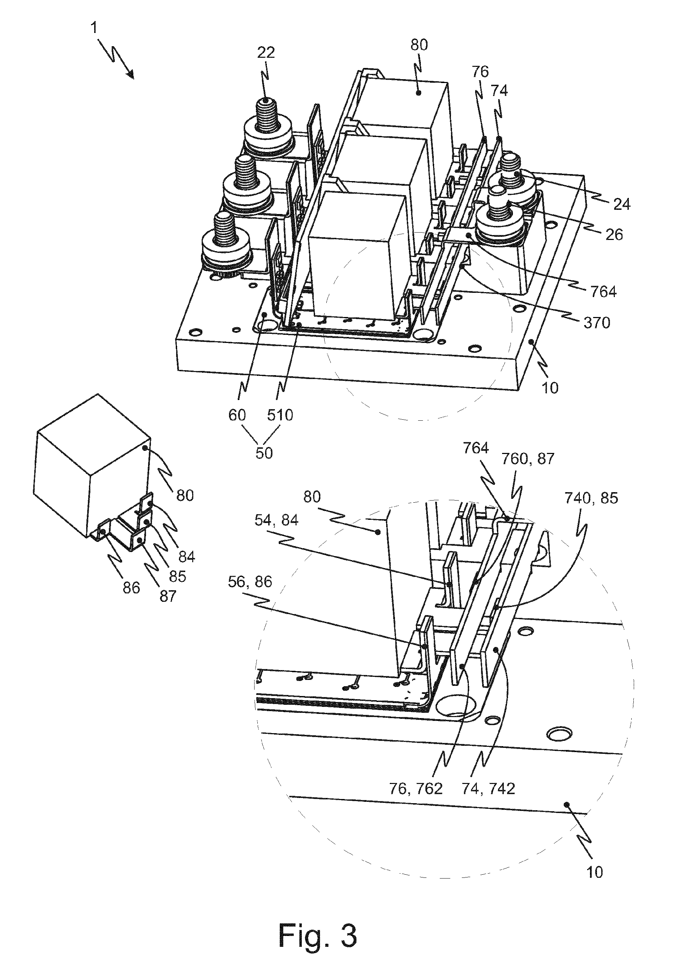

Fig. 2 zeigt eine Draufsicht auf das erfindungsgemäße leistungselektronische System 1 ohne Gehäuse, während Fig. 3 dieses nochmals in dreidimensionaler Darstellung zeigt.

Dargestellt ist eine Kühleinrichtung 10 zur Anordnung von einzelnen Subsystemen 30, 31. Es sind jeweils zwei erste 30 und ein zweites Subsystem 31 vorgesehen, wobei jedes dieser Subsysteme 30, 31 eine leistungselektronische Schaltung in Halbbrückentopologie beinhaltet wodurch das leistungselektronische System 1 eine Drei-Phasen-Brückenschaltung ausbildet.

Die beiden ersten Subsysteme 30 weisen jeweils eine leistungselektronische Schaltung auf, die mit einem Substrat 510 und einem Kühlbauteil 60 die Schalteinrichtung 50 des Subsystems 30, 31 bildet. Von der jeweiligen Schalteinrichtung 50 gehen interne Anschlusselemente 52, 54, 56, 58 aus. Hier dargestellt sind die jeweils zwei interne Gleichspannungs-Lastanschlusselemente 54, 56, ein Wechselspannungs-Lastanschlusselement 52 und eine Mehrzahl von Steueranschlusselementen 58.

Die internen Lastanschlusselemente 52, 54, 56 sind jeweils als flächige Laschen ausgebildet. Das interne Wechselspannungs-Lastanschlusselement 52 weist einen hierauf angeordneten elektrisch isolierten Stromsensor 520 auf. In seinem Verlauf ist dieses interne Wechselspannungs-Lastanschlusselement 52 mit dem externen Wechselspannungs-Lastanschlusselement 22 kraft- oder vorzugsweise stoffschlüssig, beispielhaft ausgebildet mittels einer Schweißverbindung, verbunden. Das externe Wechselspannungs-Lastanschlusselement 22 ragt wie in Fig. 1 dargestellt durch das hier nicht dargestellte Gehäuse hindurch.

Angeordnet ist das externe Wechselspannungs-Lastanschlusselement 22 auf einem, nur in Fig. 2 vollständig dargestellten, lsolierstoffkörper 32, 33 , der ebenfalls Teil des ersten Subsystems 30, 31 ist. Dieser lsolierstoffkörper 32, 33 umschließt weiterhin rahmenartig die Schalteinrichtung 50 und weist Befestigungseinrichtungen 300 auf, um das jeweilige Subsystem 30, 31 und damit auch die Schalteinrichtung 50 zur Kühleinrichtung 10 zu fixieren.

Weiterhin weist jeder lsolierstoffkörper 32, 33 eine Halteeinrichtung zur Fixierung einer zugeordneten Schaltplatine 38, die die Steuerschaltung für das Subsystem 50 beinhaltet, auf. Diese Schaltplatine 38 ist hier in unmittelbarer Nähe zum internen Wechselspannungs-Lastanschlusselement 52 vorgesehen, um einerseits kurze Verbindungswege mit den internen Hilfsanschlusselementen 58 der Schalteinrichtung, wie auch mit dem auf dem internen Wechselspannungs-Lastanschlusselement 52 angeordneten Stromsensor 520 zu erlauben. Zur kompakten Ausgestaltung des gesamten leistungselektronischen Systems 1 ist die Schaltplatine 38 hier stehend, also unter einem Winkel zwischen 60° und 90°zur Schalteinrichtung 50, vorgesehen.

Ebenso dargestellt ist eine Kondensatoreinrichtung 80 je Subsystem 30, 31, die zu ihrer Fixierung, also ihrer mechanischen Befestigung, mit dem lsolierstoffkörper 32, 33 verbunden und hier sogar teilweise von diesem umschlossen bzw. umrahmt ist. Die Anschlusselemente 84, 86 der Kondensatoreinrichtungen 80 sind polaritätsrichtig mit den internen Gleichspannungs-Lastanschlusselementen 54, 56 der zugeordneten Schalteinrichtung verbunden.

Zur Gleichspannungsversorgung weist das leistungselektronische System 1 zwei externe Gleichspannungs-Lastanschlusselemente 24, 26, eines mit positiver und eines mit negativer Polarität, auf, die beide Teil eines zweiten Subsystems 31 sind, das zwischen den beiden ersten Subsystemen 30 auf bzw. zu der Kühleinrichtung 10 angeordnet ist. Die externen Gleichspannungs-Lastanschlusselemente 24, 26 des zweiten Subsystems 31 sind mit zwei Verbindungseinrichtungen 74, 76 elektrisch leitend verbunden.

Diese Verbindungseinrichtungen 74, 76 sind hierzu als flächige Metallformkörper ausgebildet mit einem flächigen Verbindungskörper 742, 762, der gleichzeitig Kontaktstellen 740, 760 zu internen Verbindungseinrichtungen 54, 56 aufweisen kann und mit einem Kontaktabschnitt 744, 764 zur jeweiligen externen Verbindungseinrichtung 24, 26. Dieser jeweilige Kontaktabschnitt 744, 764 ist als eine Lasche ausgebildet, die eine Ausnehmung aufweist. Die externe Kontakteinrichtung 24, 26 ist hier als ein Schraubbolzen ausgebildet, der durch das Gehäuse, vgl. Fig. 1, des leistungselektronischen Systems 1 hindurchragt und im Inneren des Gehäuse durch dies Ausnehmung der Lasche des Kontaktabschnitts 744, 764 hindurchragt.

Der jeweilige flächige Verbindungskörper 742, 762 weist vorteilhafterweise direkt wie hier dargestellt Kontaktstellen 740, 760 auf. Ebenso könnte es vorteilhaft sein, diese Kontaktstellen als Laschen auszubilden, die von dem Verbindungskörper parallel oder unter einem Winkel wegstehen. Diese Kontaktstellen 740, 760 können der direkten elektrisch leitenden Verbindung zu intern Verbindungseinrichtungen 54, 56 der ersten und zweiten Submodule 30, 31 dienen. Hier dargestellte ist allerdings eine weitere bevorzugte Ausgestaltung.

Hierzu weist das leistungselektronische System 1 je erstem und zweitem Subsystem 30, 31 eine Kondensatoreinrichtung 80 auf, die je Polarität zwei Laschen 84, 85, 86, 87 aufweisen, wobei die erste 84, 86 mit der polaritätsrichtig zugeordneten Lasche 54, 56 der Schalteinrichtung 50 kraft- oder stoffschlüssig elektrisch leitend verbunden ist und die zweite 85, 87 auf dem Metallformkörper, insbesondere auf Kontaktstellen 740, 760 des Verbindungskörpers 742, 762, einer polaritätsrichtig zugeordneten Verbindungseinrichtung 74, 76 aufliegt und dort kraft- oder stoffschlüssig mit dieser kraft-oder stoffschlüssig elektrisch leitend verbunden ist.

Somit sind die Verbindungseinrichtungen 74, 76 nicht direkt mit den Schalteinrichtungen 50 der Subsysteme 30, 31 sondern über diesen zugeordnet Laschen 84, 86 der jeweiligen Kondensatoreinrichtung 80 verbunden. Dies weist den Vorteil auf, dass in einem ersten Produktionsschritt die Submodule 30, 31 einschließlich Kondensatoreinheit 80 vollständig montiert werden können. Erst bei Anordnung der Submodule 30, 31 zu einem leistungselektronischen System 1 werden die einzelnen ersten 30 und zweiten Submodule 31 mittels der Verbindungseinrichtungen 74, 76 verbunden.

Besonders deutlich ist in Fig. 2 die grundsätzliche Analogie der ersten 30 und zweiten Subsysteme 31 erkennbar, die sich nur durch das Vorhandensein von externen Gleichspannungs-Lastanschlusselementen 24, 26 und der zugehörigen Befestigung durch den lsolierstoffkörper 33 unterscheiden. Ebenso wird hier der modulare Aufbau besonders offensichtlich, der grundsätzlich eine beliebige Aneinanderreihung von ersten 30 und zweiten Subsystem 31 ermöglicht.

Fig. 3 zeigt demgegenüber besonders deutlich die vorteilhafte Ausgestaltung der Verbindungseinrichtungen 74, 76, die hier in zugeordneten Führungs- und Halteeinrichtungen 370 der jeweiligen lsolierstoffkörper 32, 33 angeordnet sind. Jeder der lsolierstoffkörper 32, 33 und damit jedes Subsystem 30, 31 weist eine rechteckige Grundform auf. Die internen 52, 54, 56 und externen Lastanschlusselemente 22, 54, 56 sind hierbei derart den Schmalseiten dieser Grundform zugeordnet, dass die lsolierstoffkörper 32, 33 und damit die Subsysteme 30, 31 über ihre Längsseiten aneinander anreihbar sind um das leistungselektronische System 1 besonders kompakt auszugestalten.

Gerade hierbei können in dem leistungselektronischen System 1 durch eine einfache Verlängerung des Verbindungskörpers 742, 762 dieser Verbindungseirichtungen 74, 76 weitere erste Submodule 30 vorgesehen werden. Ebenso wäre es möglich weitere zweite Submodule 31 mit zusätzlichen externen Lastanschlusselementen 54, 56 vorzusehen. Zudem ist durch die Lage und Ausgestaltung der Gleichstrom-Verbindungseinrichtungen 74, 76 eine niederinduktive, weil im gesamten Verlauf eng benachbarte Anordnung, möglich.

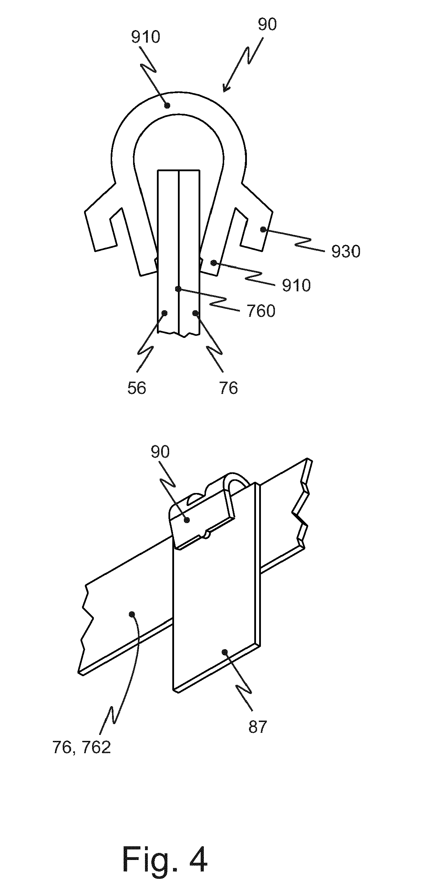

Fig. 4 zeigt zwei geringfügig unterschiedliche Ausgestaltungen eine Klemmvorrichtung 90 zur Ausbildung kraftschlüssiger Verbindungen in einem erfindungsgemäßen leistungselektronischen System 1. Eine derartige Klemmvorrichtung weist zwei Kontaktelemente 910 und mindestens, hier genau ein Federelement 920 auf. Das Federelement 910 verbindet die beiden Kontaktelemente 920, und bildet somit eine Klammer aus, wobei die Kontaktelemente 910 einander gegenüberliegen.

Vorteilhafterweise weist eine der dargestellten Klemmvorrichtungen 90 noch Montagehilfen 930auf, mit deren Hilfe die Kontaktelemente 910 auseinander gespreizt werden können um sie zu den Verbindungspartner, beispielhaft hier als eine Verbindungseinrichtung 76 und ein internes Lastanschlusselement 56 dargestellt, anzuordnen.

Vorteilhafterweise sind die Verbindungspartner Laschen 56, 86 der Schalteinrichtungen 50 und der zugeordneten Kondensatoreinrichtungen 80 wie auch Laschen 87 der Kondensatoreinrichtung 80 und Kontaktstellen 760 des Verbindungskörpers 762 der jeweiligen Verbindungseinrichtungen 76.

## Patentansprüche

1. Leistungselektronisches System (1) mit einer Kühleinrichtung (10), mindestens einem ersten (30) und mindestens einem zweiten Subsystem (31), mindestens einer Verbindungseinrichtung (74, 76) und einem Gehäuse (20), wobei das mindestens eine erste Subsystem (30) eine Schalteinrichtung (50) mit einem mit der Kühleinrichtung (10) thermisch leitend verbundenen Kühlbauteil (60) und einer hierauf angeordneten leistungselektronischen Schaltung (510) mit ersten internen Lastanschlusselementen (52, 54, 56) verschiedener Polarität und einen lsolierstoffkörper (32) aufweist,
das mindestens eine zweite Subsystem (31) analog dem ersten Subsystem (30) aufgebaut ist und mindestens ein externes Gleichspannungs-Lastanschlusselement (24, 26) aufweist,
mindestens eine Verbindungseinrichtung (74, 76) interne Lastanschlusselemente (54, 56) erster (30) und zweiter Subsysteme (31) mit einem externen Lastanschlusselement (24, 26) mindestens eines zweiten Subsystems (31) polaritätsrichtig elektrisch leitend verbindet und wobei
das Gehäuse (20) alle Subsystem (30, 31) zur Kühleinrichtung (10) hin überdeckt.

2. Leistungselektronisches System nach Anspruch 1, wobei
die mindestens eine Verbindungseinrichtung (74, 76) als flächiger Metallformkörper (742, 762) mit mindestens einem Kontaktabschnitt (744, 764) zu einer externen Kontakteinrichtung (24, 26) ausgebildet ist.

3. Leistungselektronisches System nach Anspruch 2, wobei
der Kontaktabschnitt (744, 764) als eine Lasche mit einer Ausnehmung ausbildet durch die externe Kontakteirichtung (24, 26) hindurchreicht.

4. Leistungselektronisches System nach Anspruch 3, wobei
die jeweilige externe Kontakteinrichtung (22, 24, 26) durch eine zugeordnete Ausnehmung (220, 240, 260) des Gehäuses (20) aus diesem herausragt.

5. Leistungselektronisches System nach Anspruch 1, wobei
mindestens ein internes Lastanschlusselement (52, 54, 56) der Subsysteme (30, 31) als Lasche ausgebildet sind.

6. Leistungselektronisches System nach Anspruch 5, wobei
die jeweilige Lasche eines internen Lastanschlusselements (52, 54, 56) teilflächige auf dem Metallformkörper (742, 762) der polaritätsrichtig zugeordneten Verbindungseinrichtung (74, 76) aufliegt und dort kraft- oder stoffschlüssig elektrisch leitend miteinander mit diesem verbunden ist.

7. Leistungselektronisches System nach Anspruch 1, wobei
jedes erste (30) und zweite Subsystem (31) eine Kondensatoreinrichtung (80) aufweist, die polaritätsrichtig elektrisch leitend mit der jeweiligen Schalteinrichtung (50)und den jeweiligen Verbindungselementen verbunden ist.

8. Leistungselektronisches System nach Anspruch 7, wobei
jede Kondensatoreinrichtung (80) je Polarität zwei Laschen (84, 85, 86, 87) aufweist, wobei die jeweils erste (84, 86) mit der polaritätsrichtig zugeordneten Lasche des internen Lastanschlusselementes (54, 56) der Schalteinrichtung (50) kraft- oder stoffschlüssig elektrisch leitend verbunden ist und die zweite (85, 87) auf dem Metallformkörper (742, 762) einer polaritätsrichtig zugeordneten Verbindungseinrichtung (74, 76) aufliegt und dort kraft- oder stoffschlüssig mit dieser kraft- oder stoffschlüssig elektrisch leitend verbunden ist.

9. Leistungselektronisches System nach Anspruch 5 oder 8, wobei die stoffschlüssige Verbindung als Schweißverbindung ausgebildet ist.

10. Leistungselektronisches System nach Anspruch 5 oder 8, wobei die kraftschlüssige Verbindung mittels einer reversibel anordenbaren Klammer (90) ausgebildet ist.
